# EUROPÄISCHE PATENTSCHRIFT

(11) **EP 3 446 341 B1**
(45) Veröffentlichungstag und Bekanntmachung des Hinweises auf die Patenterteilung: **27.03.2024**
(21) Anmeldenummer: 17718070.0
(22) Anmeldetag: 18.04.2017
(51) Int. Cl.: H10N 35/00, F16K 31/08, F16F 15/00, G02B 26/08, H02K 41/02, F01L 9/20, F03G 7/06, F16F 15/03, F16F 15/06, F16K 31/06, H01F 7/121, H01F 7/16

(54) **AKTORVORRICHTUNG UND VERFAHREN ZUM BETRIEB EINER AKTORVORRICHTUNG**
ACTUATOR DEVICE AND METHOD FOR OPERATING AN ACTUATOR DEVICE
DISPOSITIF ACTIONNEUR ET PROCÉDÉ POUR FAIRE FONCTIONNER UN DISPOSITIF ACTIONNEUR

(30) Priorität: 22.04.2016 DE 102016107461
(43) Veröffentlichungstag der Anmeldung: 27.02.2019
(73) Patentinhaber: ETO MAGNETIC GmbH, 78333 Stockach (DE)
(72) Erfinder: SCHIEPP, Thomas, 78606 Seitingen-Oberflacht (DE); LAUFENBERG, Markus, 78333 Stockach (DE)
(74) Vertreter: Daub, Thomas
(86) Internationale Anmeldenummer: PCT/EP2017/059198
(87) Internationale Veröffentlichungsnummer: WO 2017/182473

(56) Entgegenhaltungen:
- WO-A1-2004/078367
- WO-A1-2008/139034
- CN-A- 1 633 021
- JP-B2- 3 767 015

## Beschreibung

### Stand der Technik

Die Erfindung geht aus von einer Aktorvorrichtung nach dem Oberbegriff des Anspruchs 1 und von einem Verfahren zum Betrieb einer Aktorvorrichtung gemäß Anspruch 17.

Aus dem Stand der Technik sind Aktorvorrichtungen mit Aktorelementen bekannt, welche mittels eines Formgedächtnismaterials bewegt werden.

Zudem ist aus der WO 2015/007416 A2 eine Aktorvorrichtung mit einem als Ankerelement ausgebildeten Aktorelement und einem aus einem magnetischen Formgedächtnislegierungsmaterial (auch bekannt als MSM-Material = Magnetic Shape Memory) bestehenden Formgedächtniselement bekannt. Weitere bekannte Vorrichtungen und Verfahren werden in CN 1633021 A, JP 3767015 B2 und WO 2004 / 078367 A1 beschrieben. Keines dieser Dokumente zeigt eine durch die Verformung eines magnetostriktiven Elements verursachte Hemmung in zwei entgegengesetzte Richtungen in Verbindung mit dem Halten einer Stellposition wie durch die unabhängigen Ansprüche definiert.

Die Aufgabe der Erfindung besteht insbesondere darin, eine gattungsgemäße Aktorvorrichtung mit verbesserten Eigenschaften hinsichtlich einer Effizienz bereitzustellen. Die Aufgabe wird durch die kennzeichnenden Merkmale des Patentanspruchs 1 sowie die Merkmale des Patentanspruchs 17 gelöst, während vorteilhafte Ausgestaltungen und Weiterbildungen der Erfindung den Unteransprüchen entnommen werden können.

### Vorteile der Erfindung

Die Erfindung geht aus von einer Aktorvorrichtung mit zumindest einer statischen Einheit, mit zumindest einem relativ zu der statischen Einheit beweglichen elektromagnetischen Aktorelement und mit zumindest einem Formgedächtniselement, welches zumindest teilweise, vorzugsweise zu wenigsten einem Großteil und besonders bevorzugt vollständig, aus einem formveränderlichen Formgedächtnismaterial besteht.

Es wird vorgeschlagen, dass das Formgedächtniselement dazu vorgesehen ist, in zumindest einem Betriebszustand eine Bewegung des Aktorelements in eine erste Bewegungsrichtung, vorteilhaft eine Expansionsrichtung des Formgedächtniselements, und in eine von der ersten Bewegungsrichtung abweichende zweite Bewegungsrichtung wie weiter durch Anspruch 1 definiert, zumindest mittels einer, vorteilhaft rein, mechanischen Verformung zumindest teilweise und vorteilhaft vollständig zu hemmen. Unter "vorgesehen" soll insbesondere speziell ausgelegt und/oder ausgestattet verstanden werden. Darunter, dass ein Objekt zu einer bestimmten Funktion vorgesehen ist, soll insbesondere verstanden werden, dass das Objekt diese bestimmte Funktion in zumindest einem Anwendungs- und/oder Betriebszustand erfüllt und/oder ausführt. Unter dem Ausdruck "zu wenigstens einem Großteil" sollen dabei insbesondere zumindest 55 %, vorteilhaft zumindest 65 %, vorzugsweise zumindest 75 %, besonders bevorzugt zumindest 85 % und besonders vorteilhaft zumindest 95 % verstanden werden. Unter einer "Aktorvorrichtung" soll in diesem Zusammenhang insbesondere zumindest ein Teil, insbesondere eine Unterbaugruppe, eines Aktors verstanden werden. Vorteilhaft ist die Aktorvorrichtung zumindest zu einer Verwendung in einem Ventil, insbesondere Sitzventil und/oder Schieberventil, und/oder einem Positionierungssystem, insbesondere optischen Positionierungssystem, insbesondere zur Positionierung optischer Bauelemente, wie beispielsweise Spiegel, Linsen und/oder anderer Optiken, vorgesehen. Die statische Einheit ist vorteilhaft als Aufnahmeeinheit und/oder Halteeinheit ausgebildet und insbesondere dazu vorgesehen, zumindest das Aktorelement und/oder das Formgedächtniselement zumindest teilweise aufzunehmen, zu halten und/oder zu lagern. Die statische Einheit kann dabei beispielsweise zumindest teilweise einer Umhausung, einem Gehäuse, einem Stator und/oder einem Flussleitmittel, insbesondere einem Ferritkern und/oder einem Eisenkern, entsprechen.

Ferner soll unter einem "elektromagnetischen Aktorelement" insbesondere ein, vorteilhaft als Stellelement und/oder Ankerelement ausgebildetes, Aktorelement verstanden werden, welches mittels eines magnetischen Signals, insbesondere eines Magnetfelds, beeinflussbar ist und insbesondere dazu vorgesehen ist, das magnetisches Signal in eine Bewegung, insbesondere eine Rotationsbewegung, eine Schwenkbewegung und/oder vorzugsweise eine Linearbewegung, umzusetzen. Insbesondere besteht das Aktorelement dabei zumindest teilweise aus einem magnetisch aktiven, insbesondere magnetischen und/oder magnetisierbaren, Material und vorteilhaft aus einem von dem Formgedächtniselement verschiedenen Material. Vorzugsweise ist das Aktorelement einstückig ausgebildet. Zudem ist das Aktorelement bevorzugt in wenigstens zwei verschiedene, vorteilhaft zumindest temporär stabile, Lagen und/oder Stellpositionen bewegbar. Besonders bevorzugt ist das Aktorelement in zumindest drei, vorteilhaft zumindest vier und besonders bevorzugt beliebig viele, verschiedene, vorteilhaft zumindest temporär stabile, Lagen und/oder Stellpositionen bewegbar. Darunter, dass ein Objekt ein weiteres Objekt "beeinflusst" soll in diesem Zusammenhang insbesondere verstanden werden, dass das weitere Objekt bei einer Abwesenheit des Objekts einen anderen Zustand und/oder eine andere Lage aufweist und/oder annimmt als bei einer Anwesenheit des Objekts. Unter "einstückig" soll ferner insbesondere zumindest stoffschlüssig verbunden und/oder miteinander ausgebildet verstanden werden. Der Stoffschluss kann beispielsweise durch einen Klebeprozess, einen Anspritzprozess, einen Schweißprozess, einen Lötprozess und/oder einen anderen Prozess hergestellt werden. Vorteilhaft soll unter einstückig jedoch aus einem Stück und/oder in einem Stück geformt verstanden werden.

Darüber hinaus soll unter einem "Formgedächtniselement" insbesondere ein, insbesondere zumindest teilweise formveränderliches, Element verstanden werden, welches zumindest eine wenigstens temporär stabile Form aufweist und vorteilhaft dazu vorgesehen ist, abhängig von wenigstens einem externen Stimulus, wie beispielsweise einem elektrischen Signal, einem thermischen Signal, einem magnetischen Signal und/oder vorteilhaft zumindest einem mechanischen Signal, eine Form, vorteilhaft zumindest eine Längserstreckung, zu verändern. Vorzugsweise ist dabei ein Volumen des Formgedächtniselements konstant. Besonders bevorzugt verbleibt das Formgedächtniselement nach einem Deaktivieren des externen Stimulus in seiner aktuellen Form und/oder Position, insbesondere zumindest temporär und/oder in einem Zustand, in welchem keine, von einer reinen Schwerkraft und/oder einem Umgebungsdruck verschiedene, externe Kraft und/oder lediglich eine unterhalb eines Grenzwert befindliche externe Kraft auf das Formgedächtniselement wirkt. Bevorzugt ist das Formgedächtniselement einstückig ausgebildet. Zudem ist das Formgedächtniselement vorteilhaft in einem Nahbereich des Aktorelements angeordnet. Unter einer "Längserstreckung" eines, insbesondere länglichen, Objekts soll in diesem Zusammenhang insbesondere eine maximale Erstreckung des Objekts verstanden werden. Unter einem "Nahbereich" soll ferner insbesondere ein räumlicher Bereich verstanden werden, welcher aus Punkten gebildet ist, die weniger als ein Drittel, vorzugsweise weniger als ein Viertel, bevorzugt weniger als ein Sechstel und besonders bevorzugt weniger als ein Zehntel einer minimalen Längserstreckung des Formgedächtniselements von einem Referenzpunkt und/oder einem Referenzbauteil, insbesondere dem Aktorelement, entfernt sind und/oder die jeweils einen Abstand von höchstens 20 mm, vorzugsweise von höchstens 10 mm und besonders bevorzugt von höchstens 5 mm von einem Referenzpunkt und/oder einem Referenzbauteil, insbesondere dem Aktorelement, aufweisen. Darunter, dass "das Formgedächtniselement dazu vorgesehen ist, eine Bewegung des Aktorelements zu hemmen" soll insbesondere verstanden werden, dass das Formgedächtniselement dazu vorgesehen ist, einer Bewegung des Aktorelements entgegenzuwirken und/oder eine Bewegung des Aktorelements zu dämpfen. Durch diese Ausgestaltung kann eine Aktorvorrichtung mit verbesserten Eigenschaften hinsichtlich einer Effizienz, insbesondere einer Energieeffizienz, einer Bauteileeffizienz, einer Bauraumeffizienz und/oder einer Kosteneffizienz, bereitgestellt werden. Zudem kann vorteilhaft eine Aktorvorrichtung mit einer, insbesondere im Vergleich zu herkömmlichen elektromagnetischen Aktoren, insbesondere Reluktanzaktoren, erhöhten Steifigkeit erreicht werden. Darüber hinaus kann vorteilhaft eine Wärmeentwicklung, wie beispielsweise bei Verwendung von Elektromagneten, reduziert und/oder vorteilhaft gänzlich vermieden werden. Zudem kann vorteilhaft eine besonders kompakte Aktorvorrichtung bereitgestellt und/oder eine Stellfunktion verbessert werden, wobei insbesondere in zumindest einem Betriebszustand eine energielose Multistabilität realisiert werden kann.

Vorzugsweise ist das Formgedächtniselement, insbesondere zumindest in dem Betriebszustand mittels der mechanischen Verformung, von einer wenigstens temporär stabilen ersten Form in zumindest eine wenigstens temporär stabile zweite Form überführbar und vorteilhaft dazu vorgesehen, das Aktorelement in der ersten Form in wenigstens einer ersten Lage und/oder Stellposition und in der zweiten Form in wenigstens einer zweiten Lage und/oder Stellposition, insbesondere zumindest temporär, zu halten. Hierdurch kann insbesondere eine vorteilhafte Stellfunktion realisiert werden.

Ist das Formgedächtniselement in zumindest eine wenigstens temporär stabile dritte Form überführbar und insbesondere dazu vorgesehen, das Aktorelement in der dritten Form in wenigstens einer dritten Lage und/oder Stellposition, insbesondere zumindest temporär, zu halten, kann insbesondere eine vorteilhafte Multistabilität erzielt werden.

Erfindungsgemäß ist das Formgedächtniselement mit dem Aktorelement verbunden. Ferner wird vorgeschlagen, dass das Formgedächtniselement mit der statischen Einheit, insbesondere unlösbar, verbunden ist. Bevorzugt kontaktiert das Formgedächtniselement das Aktorelement und/oder die statische Einheit dabei unmittelbar. Hierdurch kann insbesondere eine vorteilhafte Kraftübertragung zwischen der statischen Einheit, dem Formgedächtniselement und dem Aktorelement erreicht werden.

In einer bevorzugten Ausgestaltung der Erfindung wird vorgeschlagen, dass das Formgedächtniselement mit dem Aktorelement und/oder der statischen Einheit mittels einer Klemmverbindung, insbesondere einer Crimpverbindung und/oder Bördelverbindung, einer Klebeverbindung, einer Vergußverbindung und/oder einer Schweißverbindung, insbesondere einer Laserschweißverbindung, verbunden ist. Hierdurch kann insbesondere eine sichere und/oder stabile Verbindung erreicht werden. Zudem kann vorteilhaft sichergestellt werden, dass das Formgedächtniselement höchstens lokal geschädigt und/oder mechanisch blockiert wird, wodurch insbesondere eine Funktionsfähigkeit des Formgedächtniselements aufrechterhalten werden kann.

Erfindungsgemäß ist die zweite Bewegungsrichtung der ersten Bewegungsrichtung entgegengesetzt. Das Aktorelement könnte dabei zumindest teilweise rotatorisch beweglich sein, wie beispielsweise gemäß einem Klappankerprinzip. Vorteilhaft ist das Aktorelement jedoch linear beweglich ausgebildet. Hierdurch kann insbesondere eine vorteilhaft einfache Beweglichkeit, insbesondere Stellbewegung und/oder Hubbewegung, des Aktorelements erreicht werden.

Des Weiteren wird vorgeschlagen, dass eine maximale Bewegungsstrecke des Aktorelements entlang zumindest einer Richtung, insbesondere entlang der ersten Bewegungsrichtung und/oder der zweiten Bewegungsrichtung, zumindest 1 %, vorteilhaft zumindest 2,5 % und besonders bevorzugt zumindest 5 % und/oder höchstens 20 % und vorteilhaft höchstens 15 % einer minimalen Erstreckung des Formgedächtniselements entlang der Richtung, vorteilhaft Längserstreckung des Formgedächtniselements, entspricht. Hierdurch kann insbesondere eine vorteilhafte Stellbewegung erreicht werden.

Zudem kann insbesondere eine Funktionsfähigkeit der Aktorvorrichtung verbessert werden.

Vorteilhaft umfasst die Aktorvorrichtung zudem zumindest eine, vorteilhaft aktiv ansteuerbare, Magnetstelleinheit, welche dazu vorgesehen ist, eine Bewegung des Aktorelements, insbesondere mittels eines Stellmagnetfelds, zu bewirken, insbesondere in die erste Bewegungsrichtung und/oder die zweite Bewegungsrichtung. Insbesondere ist die Magnetstelleinheit dazu vorgesehen, das Stellmagnetfeld bereitzustellen und/oder vorteilhaft zu erzeugen. Vorteilhaft weist die Magnetstelleinheit dabei eine Wirkverbindung mit zumindest einer Versorgungselektronik auf. Insbesondere kann die Aktorvorrichtung dabei die Versorgungselektronik umfassen. Die Magnetstelleinheit könnte dabei insbesondere als Permanentmagnet ausgebildet sein und beispielsweise beweglich relativ zu dem Aktorelement und/oder dem Formgedächtniselement gelagert sein. Vorteilhaft ist die Magnetstelleinheit jedoch als Spulensystem, vorteilhaft mit zumindest einer Spule und/oder mit zumindest einem Elektromagneten, ausgebildet. Hierdurch kann insbesondere eine vorteilhaft einfache Bewegung des Aktorelements erreicht werden. Zudem kann insbesondere eine Bauraumeffizienz, eine Bauteileeffizienz, eine Energieeffizienz und/oder eine Kosteneffizienz vorteilhaft optimiert werden.

Weiter wird vorgeschlagen, dass das Formgedächtnismaterial zumindest teilweise, vorzugsweise zu wenigstens einem Großteil und besonders bevorzugt vollständig, aus einer Nickel-Titan Legierung, einer Nickel-Titan-haltigen Legierung, einer Nickel-Mangan-Gallium Legierung, einer Nickel-Mangan-Gallium-haltigen Legierung, einer Kupfer-Zink-Aluminium Legierung und/oder einer Kupfer-Aluminium-Nickel Legierung besteht. Hierdurch können insbesondere Kosten minimiert und/oder eine Wirksamkeit verbessert werden.

Vorzugsweise ist das Formgedächtnismaterial als Kompositmaterial ausgebildet, welches insbesondere Bestandteile aus Nickel, Titan, Mangan, Gallium, Kupfer, Zink und/oder Aluminium aufweist, welche in einer Matrix, wie beispielsweise einer Metallmatrix, einer Polymermatrix und/oder einer keramischen Matrix, eingebettet sind. Hierdurch kann insbesondere eine besonders hohe Steifigkeit und/oder Bewegungsdämpfungswirkung erreicht werden.

Das Formgedächtnismaterial könnte beispielsweise ein thermisch aktives Material sein. Vorzugsweise ist das Formgedächtnismaterial jedoch ein magnetisch aktives Material, insbesondere ein magnetisches Formgedächtnismaterial, wodurch insbesondere eine vorteilhaft einfache Beeinflussung des Formgedächtnismaterials und insbesondere des Formgedächtniselements erreicht werden kann. Besonders bevorzugt ist das Formgedächtnismaterial dabei eine magnetische Formgedächtnislegierung (auch bekannt als MSM-Material = Magnetic Shape Memory).

Darüber hinaus wird vorgeschlagen, dass die Aktorvorrichtung zumindest eine, vorteilhaft aktiv ansteuerbare, Magneteinheit aufweist, welche dazu vorgesehen ist, in zumindest einem weiteren Betriebszustand, insbesondere mittels eines Magnetfelds, eine Form des Formgedächtniselements zu beeinflussen. Insbesondere ist die Magneteinheit dazu vorgesehen, das Magnetfeld bereitzustellen und/oder vorteilhaft zu erzeugen. Vorteilhaft weist die Magneteinheit dabei eine Wirkverbindung mit zumindest einer weiteren Versorgungselektronik auf. Insbesondere kann die Aktorvorrichtung die weitere Versorgungselektronik umfassen. Vorzugsweise ist die weitere Versorgungselektronik mit der Versorgungselektronik identisch. Die Magneteinheit könnte dabei insbesondere als Permanentmagnet ausgebildet sein und beispielsweise beweglich relativ zu dem Formgedächtniselement und/oder dem Aktorelement gelagert sein. Vorteilhaft ist die Magneteinheit jedoch als Spulensystem, vorteilhaft mit zumindest einer Spule und/oder mit zumindest einem Elektromagneten, ausgebildet. Besonders bevorzugt sind die Magneteinheit und die Magnetstelleinheit zumindest teilweise miteinander identisch. Insbesondere kann der weitere Betriebszustand prinzipiell auch dem Betriebszustand entsprechen. Hierdurch kann insbesondere eine Steifigkeit des Formgedächtniselements und damit insbesondere eine mechanische Haltekraft und/oder Dämpfungskraft des Formgedächtniselements eingestellt werden. Zudem kann vorteilhaft eine Einstellung und/oder Ausrichtung des Formgedächtniselements erreicht werden.

Ferner wird vorgeschlagen, dass die Magneteinheit dazu vorgesehen ist, in dem weiteren Betriebszustand mittels eines Formveränderungsmagnetfelds eine Verformung des Formgedächtniselements zu bewirken und das Formgedächtniselement dazu vorgesehen ist, eine Bewegung des Aktorelements in die erste Bewegungsrichtung und/oder die zweite Bewegungsrichtung mittels der magnetischen Verformung zumindest teilweise zu hemmen, wobei die magnetische Verformung vorteilhaft mit der mechanischen Verformung des Formgedächtniselements zusammenwirkt. Zudem wird vorteilhaft vorgeschlagen, dass die Magneteinheit dazu vorgesehen ist, in dem weiteren Betriebszustand mittels eines weiteren Formveränderungsmagnetfelds eine Verformung des Formgedächtniselements zu bewirken und das Formgedächtniselement dazu vorgesehen ist, eine Bewegung des Aktorelements in die erste Bewegungsrichtung und/oder die zweite Bewegungsrichtung mittels der magnetischen Verformung zu bewirken. Hierdurch kann eine vorteilhafte Steuerung und/oder Einstellung der Aktorvorrichtung realisiert werden.

In einer bevorzugten Ausgestaltung der Erfindung wird ferner vorgeschlagen, dass die Aktorvorrichtung zumindest eine Sicherungseinheit aufweist, welche dazu vorgesehen ist, in zumindest einem Fehlerbetriebszustand, wie beispielsweise bei einer Überschreitung einer bestimmten Temperatur, bei einem Defekt oder Ausfall eines Bauteils der Aktorvorrichtung, wie beispielsweise der Versorgungselektronik und/oder des Aktorelements, und/oder bei einem Stromausfall, eine Bewegung des Aktorelements und/oder des Formgedächtniselements in eine definierte Form und/oder Lage zu bewirken. Insbesondere kann die Sicherungseinheit dabei zumindest ein Energiespeicherelement, wie beispielsweise einen Akkumulator, eine Batterie und/oder einen Kondensator, aufweisen, insbesondere um eine Bewegung des Aktorelements und/oder des Formgedächtniselements in dem Fehlerbetriebszustand zu bewirken. Hierdurch kann insbesondere eine Betriebssicherheit verbessert werden. Zudem kann eine vorteilhafte Fail-Safe-Funktion und/oder Notabschaltung realisiert werden.

Zudem wird ein Verfahren zum Betrieb einer Aktorvorrichtung gemäß Anspruch 17 offenbart.

Hierdurch kann insbesondere eine Effizienz, insbesondere eine Energieeffizienz, eine Bauteileeffizienz, eine Bauraumeffizienz und/oder eine Kosteneffizienz, verbessert werden. Zudem kann vorteilhaft eine Aktorvorrichtung mit einer, insbesondere im Vergleich zu herkömmlichen elektromagnetischen Aktoren, insbesondere Reluktanzaktoren, erhöhten Steifigkeit erreicht werden. Darüber hinaus kann vorteilhaft eine Wärmeentwicklung, wie beispielsweise bei Verwendung von Elektromagneten, reduziert und/oder vorteilhaft gänzlich vermieden werden. Zudem kann vorteilhaft eine besonders kompakte Aktorvorrichtung bereitgestellt und/oder eine Stellfunktion verbessert werden, wobei insbesondere in zumindest einem Betriebszustand eine energielose Multistabilität realisiert werden kann.

Die Aktorvorrichtung und das Verfahren zum Betrieb der Aktorvorrichtung sollen hierbei nicht auf die oben beschriebene Anwendung und Ausführungsform beschränkt sein. Insbesondere kann die Aktorvorrichtung und das Verfahren zum Betrieb der Aktorvorrichtung zu einer Erfüllung einer hierin beschriebenen Funktionsweise eine von einer hierin genannten Anzahl von einzelnen Elementen, Bauteilen und Einheiten abweichende Anzahl aufweisen.

### Zeichnungen

Weitere Vorteile ergeben sich aus der folgenden Zeichnungsbeschreibung. In den Zeichnungen sind Ausführungsbeispiele der Erfindung dargestellt. Die Zeichnungen, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:
- Fig. 1: ein Aktor mit einer Aktorvorrichtung in einer schematischen Seitenansicht,
- Fig. 2a-e: der Aktor mit der Aktorvorrichtung in verschiedenen Betriebszuständen,
- Fig. 3: ein weiterer Aktor mit einer weiteren Aktorvorrichtung in einer schematischen Seitenansicht,
- Fig. 4: ein Ventil mit einer weiteren Aktorvorrichtung in einer schematischen Seitenansicht und
- Fig. 5: ein Positionierungssystem mit zumindest einer weiteren Aktorvorrichtung in einer schematischen Seitenansicht.

### Beschreibung der Ausführungsbeispiele

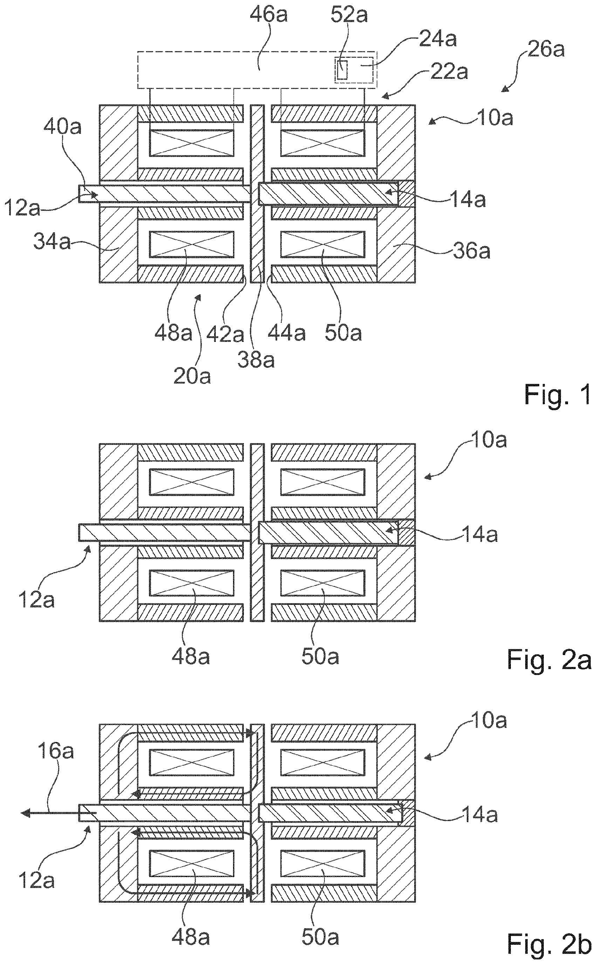

Figur 1 zeigt einen beispielhaften Aktor 26a mit einer Aktorvorrichtung in einer schematischen Ansicht.

Die Aktorvorrichtung umfasst eine statische Einheit 10a. Die statische Einheit 10a ist als Aufnahmeeinheit ausgebildet. Die statische Einheit 10a ist dazu vorgesehen, zumindest einen Großteil der für einen Betrieb der Aktorvorrichtung benötigten Bauteile aufzunehmen und/oder zu lagern. Im vorliegenden Fall ist die statische Einheit 10a ferner zumindest zweiteilig ausgebildet. Die statische Einheit 10a umfasst dabei zwei statische Elemente 34a, 36a. Die statischen Elemente 34a, 36a sind zumindest im Wesentlichen identisch zueinander. Die statischen Elemente 34a, 36a sind zumindest im Wesentlichen W-förmig und/oder E-förmig ausgebildet. Die statischen Elemente 34a, 36a sind beabstandet zueinander angeordnet, sodass insbesondere ein Freiraum zwischen den statischen Elementen 34a, 36a existiert. Die statischen Elemente 34a, 36a sind zudem spiegelsymmetrisch relativ zueinander angeordnet. Die statischen Elemente 34a, 36a sind derart angeordnet, dass sie einen gemeinsamen Aufnahmebereich begrenzen.

Ferner ist die statische Einheit 10a zumindest teilweise als Flussleitmittel ausgebildet und bildet insbesondere zumindest einen Teil wenigstens eines Magnetkreises. Die statische Einheit 10a ist dabei dazu vorgesehen, ein Magnetfeld zumindest teilweise zu führen und/oder zu verstärken. Im vorliegenden Fall sind die statischen Elemente 34a, 36a jeweils als ein Ferritkern ausgebildet. Alternativ ist denkbar, eine statische Einheit als Halteeinheit, Begrenzungseinheit und/oder als Gehäuse, insbesondere Innengehäuse und/oder Außengehäuse, auszubilden. Zudem könnte eine statische Einheit auch einstückig ausgebildet sein. Ferner könnte eine statische Einheit prinzipiell auch von einem Flussleitmittel verschieden ausgebildet sein.

Darüber hinaus umfasst die Aktorvorrichtung zumindest ein Aktorelement 12a. Im vorliegenden Fall umfasst die Aktorvorrichtung genau ein Aktorelement 12a. Das Aktorelement 12a ist einstückig ausgebildet. Das Aktorelement 12a ist als Stellelement ausgebildet. Das Aktorelement 12a ist zudem als Ankerelement ausgebildet. Darüber hinaus weist das Aktorelement 12a einen T-förmigen Querschnitt auf. Das Aktorelement 12a ist zu wenigstens einem Großteil innerhalb der statischen Einheit 10a, insbesondere innerhalb des Aufnahmebereichs, angeordnet. Das Aktorelement 12a ist dabei beweglich relativ zu der statischen Einheit 10a gelagert. Im vorliegenden Fall ist das Aktorelement 12a in eine erste Bewegungsrichtung 16a und in eine der ersten Bewegungsrichtung 16a entgegengesetzte zweite Bewegungsrichtung 18a beweglich (vgl. auch Figuren 2a - 2e).

Das Aktorelement 12a ist ferner als elektromagnetisches Aktorelement ausgebildet. Das Aktorelement 12a besteht zumindest teilweise aus einem magnetisch aktiven, insbesondere magnetischen und/oder magnetisierbaren, Material. Das Aktorelement 12a ist somit mittels eines Magnetfelds bewegbar.

Ein Stellabschnitt 38a des Aktorelements 12a, insbesondere ein Querbalken des T-förmigen Querschnitts, welcher insbesondere zwei freie Enden aufweist, ist zwischen den statischen Elementen 34a, 36a angeordnet. Der Stellabschnitt 38a ist dabei in dem Freiraum angeordnet. Der Stellabschnitt 38a ist im vorliegenden Fall vollständig innerhalb der statischen Einheit 10a angeordnet. Der Stellabschnitt 38a dient zu einer Bewegung des Aktorelements 12a. Der Stellabschnitt 38a ist dabei als Flussleitmittel ausgebildet und insbesondere dazu vorgesehen, in zumindest einem Betriebszustand mit dem Magnetkreis der statischen Einheit 10a zusammenzuwirken. Ferner definieren den Freiraum begrenzende Seitenflächen der statischen Elemente 34a, 36a Anschlagflächen 42a, 44a für den Stellabschnitt 38a. Die Anschlagflächen 42a, 44a sind parallel zueinander angeordnet. Das Aktorelement 12a und insbesondere der Stellabschnitt 38a ist zwischen den Anschlagflächen 42a, 44a frei bewegbar. Ein Abstand der Anschlagflächen 42a, 44a begrenzt eine maximale Bewegungsstrecke des Aktorelements 12a. Im vorliegenden Fall ist das Aktorelement 12a dabei in eine Vielzahl verschiedene Stellpositionen, insbesondere zwischen den Anschlagflächen 42a, 44a, bewegbar.

Ein Betätigungsabschnitt 40a des Aktorelements 12a, insbesondere ein Längsbalken des T-förmigen Querschnitts, welcher insbesondere ein freies Ende aufweist, ist aus der statischen Einheit 10a hinausgeführt. Der Betätigungsabschnitt 40a ist senkrecht zu dem Stellabschnitt 38a angeordnet. Der Betätigungsabschnitt 40a ist zu einem Betrieb, einem Antrieb, zu einer Positionierung und/oder zu einer Einstellung zumindest eines Bauteils vorgesehen. Grundsätzlich könnte eine Aktorvorrichtung jedoch auch eine andere Anzahl an Aktorelementen aufweisen, wie beispielsweise zumindest zwei Aktorelemente und/oder zumindest drei Aktorelemente. Zudem ist denkbar, ein Aktorelement mehrteilig auszubilden. Ferner könnte ein Aktorelement prinzipiell auch monostabil oder bistabil ausgestaltet werden. Darüber hinaus könnte ein Aktorelement zumindest im Wesentlichen I-förmig und/oder L-förmig ausgebildet sein.

Zu einer Bewegung des Aktorelements 12a umfasst die Aktorvorrichtung eine Magnetstelleinheit 20a. Die Magnetstelleinheit 20a ist in einem Nahbereich des Aktorelements 12a angeordnet. Die Magnetstelleinheit 20a ist aktiv ansteuerbar. Die Magnetstelleinheit 20a weist eine Wirkverbindung mit einer Versorgungselektronik 46a der Aktorvorrichtung auf. Die Magnetstelleinheit 20a ist dazu vorgesehen, zumindest ein Stellmagnetfeld zu erzeugen.

Dazu ist die Magnetstelleinheit 20a als Spulensystem ausgebildet. Die Magnetstelleinheit 20a umfasst im vorliegenden Fall zwei Induktivitäten 48a, 50a. Die Induktivitäten 48a, 50a sind zumindest im Wesentlichen identisch zueinander. Die Induktivitäten 48a, 50a sind im vorliegenden Fall jeweils als eine Spule ausgebildet. Die Induktivitäten 48a, 50a weisen jeweils eine elektrische Verbindung mit der Versorgungselektronik 46a auf. Die Induktivitäten 48a, 50a sind vollständig innerhalb der statischen Einheit 10a, insbesondere innerhalb des Aufnahmebereichs, angeordnet. Eine erste Induktivität 48a der Induktivitäten 48a, 50a ist dabei einem ersten statischen Element 34a der statischen Elemente 34a, 36a zugeordnet. Eine zweite Induktivität 50a der Induktivitäten 48a, 50a ist einem zweiten statischen Element 36a der statischen Elemente 34a, 36a zugeordnet. Die statischen Elemente 34a, 36a sind dabei dazu vorgesehen, Magnetfeldlinien der Induktivitäten 48a, 50a zumindest teilweise zu leiten und hierdurch vorteilhaft eine Feldstärke der Induktivitäten 48a, 50a zumindest teilweise zu erhöhen. Zudem sind die Induktivitäten 48a, 50a auf unterschiedlichen Seiten des Stellabschnitts 38a angeordnet. Die erste Induktivität 48a ist auf einer dem Betätigungsabschnitt 40a zugewandten Seite des Stellabschnitts 38a angeordnet. Die zweite Induktivität 50a ist auf einer dem Betätigungsabschnitt 40a abgewandten Seite des Stellabschnitts 38a angeordnet.

Die erste Induktivität 48a ist im vorliegenden Fall dazu vorgesehen, bei einer Bestromung und insbesondere mittels eines hierdurch erzeugten ersten Stellmagnetfelds eine Bewegung des Stellabschnitts 38a und somit insbesondere des Aktorelements 12a in die erste Bewegungsrichtung 16a zu bewirken. Ferner ist die zweite Induktivität 50a dazu vorgesehen, bei einer Bestromung und insbesondere mittels eines hierdurch erzeugten zweiten Stellmagnetfelds, eine Bewegung des Stellabschnitts 38a und somit insbesondere des Aktorelements 12a in die zweite Bewegungsrichtung 18a zu bewirken.

Alternativ könnte eine Magnetstelleinheit auch andere Arten von Induktivitäten und/oder eine abweichende Anzahl an Induktivitäten, wie beispielsweise zumindest drei und/oder zumindest vier Induktivitäten, aufweisen.

Des Weiteren weist die Aktorvorrichtung zumindest ein Formgedächtniselement 14a auf. Im vorliegenden Fall umfasst die Aktorvorrichtung genau ein Formgedächtniselement 14a. Grundsätzlich könnte eine Aktorvorrichtung jedoch auch eine andere Anzahl an Formgedächtniselementen aufweisen, wie beispielsweise zumindest zwei und/oder zumindest drei Formgedächtniselemente, welche insbesondere parallel und/oder seriell zueinander angeordnet sein können.

Das Formgedächtniselement 14a ist zu wenigstens einem Großteil innerhalb der statischen Einheit 10a, insbesondere innerhalb des Aufnahmebereichs, angeordnet. Das Formgedächtniselement 14a ist dabei auf der dem Betätigungsabschnitt 40a abgewandten Seite des Stellabschnitts 38a angeordnet. Das Formgedächtniselement 14a ist in einem Nahbereich der zweiten Induktivität 50a angeordnet. Im vorliegenden Fall ist das Formgedächtniselement 14a in einem zentralen Bereich der zweiten Induktivität 50a angeordnet. Das Formgedächtniselement 14a ist ferner einstückig ausgebildet. Das Formgedächtniselement 14a ist zumindest im Wesentlichen quaderförmig ausgebildet. Das Formgedächtniselement 14a ist länglich ausgebildet und weist eine, insbesondere in Figur 1 horizontal angeordnete, Längserstreckung auf. Die Längserstreckung des Formgedächtniselement 14a ist dabei parallel zu einer Längserstreckung des Betätigungsabschnitts 40a ausgerichtet. Im vorliegenden Fall sind das Formgedächtniselement 14a und der Betätigungsabschnitts 40a auf einer gemeinsamen Geraden hintereinander angeordnet.

Zudem kontaktiert das Formgedächtniselement 14a die statische Einheit 10a unmittelbar. Im vorliegenden Fall kontaktiert zumindest eine erste Stirnseite des Formgedächtniselements 14a die statische Einheit 10a unmittelbar. Das Formgedächtniselement 14a ist dabei mit der statischen Einheit 10a verbunden, im vorliegenden Fall insbesondere mittels einer Laserschweißverbindung. Ferner kontaktiert das Formgedächtniselement 14a das Aktorelement 12a unmittelbar. Im vorliegenden Fall kontaktiert eine, insbesondere der ersten Stirnseite gegenüberliegende, zweite Stirnseite des Formgedächtniselements 14a den Stellabschnitt 38a des Aktorelements 12a unmittelbar. Das Formgedächtniselement 14a ist dabei mit dem Aktorelement 12a verbunden, insbesondere mittels einer Laserschweißverbindung. Eine maximale Bewegungsstrecke des Aktorelements 12a entlang der ersten Bewegungsrichtung 16a und der zweiten Bewegungsrichtung 18a entspricht im vorliegenden Fall zumindest 5 % der Längserstreckung des Formgedächtniselements 14a. Zudem entspricht eine maximale Bewegungsstrecke des Aktorelements 12a entlang der ersten Bewegungsrichtung 16a und der zweiten Bewegungsrichtung 18a höchstens 20 % der Längserstreckung des Formgedächtniselements 14a. Eine hohe Dehnung des Formgedächtniselements 14a ist dabei vorteilhaft, um bei gegebenem Hub des Aktors 26a ein möglichst kurzes Formgedächtniselement 14a verwenden zu können. Alternativ ist denkbar, ein Formgedächtniselement mittels einer anderen Verbindungsmethode mit einer statischen Einheit und/oder mit einem Aktorelement zu verbinden, wie beispielsweise mittels einer Klemmverbindung und/oder einer Klebeverbindung oder dergleichen. Zudem könnte eine Verbindungsmethode zur Verbindung eines Formgedächtniselements mit einer statischen Einheit von einer Verbindungsmethode zur Verbindung des Formgedächtniselements mit einem Aktorelement abweichen. Ferner könnte ein Formgedächtniselement prinzipiell auch mittelbar mit einem Aktorelement und/oder einer statischen Einheit verbunden sein.

Darüber hinaus ist das Formgedächtniselement 14a formveränderlich ausgebildet. Das Formgedächtniselement 14a besteht aus einem formveränderlichen Formgedächtnismaterial. Das Formgedächtnismaterial entspricht im vorliegenden Fall einem magnetisch aktiven Material, insbesondere einem magnetischen Formgedächtnismaterial. Das Formgedächtniselement 14a besteht dabei aus einer Nickel-Mangan-Gallium Legierung. Das Formgedächtniselement 14a ist ferner als Einkristall ausgebildet. Alternativ könnte ein Formgedächtniselement jedoch auch aus einer Nickel-Mangan-Gallium-haltigen Legierung, einer Nickel-Titan Legierung, einer Nickel-Titan-haltigen Legierung, einer Kupfer-Zink-Aluminium Legierung und/oder einer Kupfer-Aluminium-Nickel Legierung bestehen. Zudem könnte ein Formgedächtniselement auch als Schaum, als Polykristall und/oder als Kompositmaterial ausgebildet sein, wobei Nickel-, Mangan- und Gallium-Bestandteile in einer Matrix eingebettet sein können. Ferner könnte ein Formgedächtniselement prinzipiell auch aus einem magnetostriktiven Material und/oder einem thermisch aktiven Formgedächtnismaterial bestehen.

Das formveränderliche Formgedächtnismaterial weist die Eigenschaft auf, dass als Reaktion auf eine mechanische Kraft mit einer definierten minimalen Stärke und einer definierten Richtung eine, insbesondere mechanische, Formveränderung, insbesondere eine Expansions- oder Kompressionsbewegung in Richtung der Längserstreckung des Formgedächtniselements 14a, stattfindet. Dabei wirkt das Formgedächtniselement 14a der mechanischen Kraft und/oder einer mechanischen Beanspruchung zumindest teilweise entgegen und führt somit zu einem gewissen Grad zu einer, insbesondere im Wesentlichen geschwindigkeitsunabhängigen, Dämpfung der mechanischen Kraft. Demnach könnte ein Aktor mit einer erfindungsgemäßen Aktorvorrichtung prinzipiell auch als Dämpfer ausgestaltet sein. Nach einer Reduktion und/oder einer Unterbrechung der mechanischen Kraft und/oder der mechanischen Beanspruchung findet jedoch nicht automatisch eine Bewegung zurück in eine Grundform und/oder Ausgangsform statt. Vielmehr verbleibt das Formgedächtniselement 14a auch nach der Reduktion und/oder der Unterbrechung der mechanischen Kraft und/oder der mechanischen Beanspruchung in der aktuellen, insbesondere expandierten und/oder komprimierten, Form, insbesondere zumindest in einem Zustand, in welchem lediglich eine geringe externe Kraft und/oder keine, von einer reinen Schwerkraft und/oder einem Umgebungsdruck verschiedene, externe Kraft auf das Formgedächtniselement 14a wirkt. Zu einer Formveränderung des Formgedächtniselements 14a muss dabei eine innere Kraft des Formgedächtniselements 14a, im vorliegenden Fall insbesondere bedingt durch eine relativ hohe Hysterese eines verwendeten Werkstoffs, überwunden werden.

Darüber hinaus handelt es sich bei einem verwendeten Material im vorliegenden Fall um ein magnetisch aktives Material, insbesondere ein magnetisches Formgedächtnismaterial. Dieses Material weist zusätzlich die Eigenschaft auf, dass als Reaktion auf ein angelegtes Magnetfeld mit einer definierten minimalen Feldstärke und einer definierten Richtung ebenfalls eine Formveränderung, insbesondere eine Expansions- oder Kompressionsbewegung in Richtung der Längserstreckung des Aktorelements 12a, stattfindet. Auch in diesem Fall findet nach einer Reduktion und/oder einem Deaktivieren des Magnetfelds nicht automatisch eine Bewegung zurück in die Grundform und/oder Ausgangsform statt, sodass das Formgedächtniselement 14a ebenfalls in der aktuellen, insbesondere expandierten und/oder komprimierten, Form verbleibt, insbesondere zumindest in einem Zustand, in welchem lediglich eine geringe externe Kraft und/oder keine, von einer reinen Schwerkraft und/oder einem Umgebungsdruck verschiedene, externe Kraft, insbesondere rückstellende Kraft, auf das Formgedächtniselement 14a wirkt. Insbesondere kann dabei mittels eines, insbesondere dauerhaft anliegenden, Magnetfelds, wie beispielswiese durch einen Elektromagneten und/oder Permanentmagneten, auch eine Gegenkraft und/oder Haltekraft entgegen einer externen Kraft, insbesondere einer rückstellenden Kraft und/oder einer Zugkraft, erzeugt werden, wodurch vorteilhaft eine Dämpfungswirkung und/oder eine aktuelle Form des Formgedächtniselements 14a eingestellt werden kann.

Im vorliegenden Fall ist das Formgedächtniselement 14a dazu vorgesehen, in zumindest einem Betriebszustand eine, insbesondere mittels der Magnetstelleinheit 20a bewirkte, Bewegung des Aktorelements 12a in die erste Bewegungsrichtung 16a, welche im vorliegenden Fall insbesondere einer Expansionsrichtung des Formgedächtniselements 14a entspricht, und in die zweite Bewegungsrichtung 18a, welche im vorliegenden Fall insbesondere einer Kompressionsrichtung des Formgedächtniselements 14a entspricht, mittels einer rein mechanischen Verformung zu hemmen. Dabei ist das Formgedächtniselement 14a mittels einer mechanischen Kraft des Aktorelements 12a von einer stabilen ersten Form in zumindest eine stabile zweite Form überführbar. Zudem ist das Formgedächtniselement 14a dazu vorgesehen, das Aktorelement 12a in der ersten Form in wenigstens einer ersten Stellposition und in der zweiten Form in wenigstens einer zweiten Stellposition zu halten. Ferner ist das Formgedächtniselement 14a multistabil ausgestaltet und im vorliegenden Fall, insbesondere mittels der mechanischen Kraft des Aktorelements 12a, in eine Vielzahl weiterer Formen überführbar, insbesondere zumindest eine dritte Form. Dabei ist das Formgedächtniselement 14a dazu vorgesehen, das Aktorelement 12a in jeder der weiteren Formen in einer Stellposition zu halten.

Darüber hinaus umfasst die Aktorvorrichtung im vorliegenden Fall eine, insbesondere zusätzliche, Magneteinheit 22a. Die Magneteinheit 22a ist dazu vorgesehen, in zumindest einem weiteren Betriebszustand, insbesondere mittels eines Magnetfelds, eine Form des Formgedächtniselements 14a zu beeinflussen.

Dazu ist die Magneteinheit 22a als Spulensystem ausgebildet. Die Magneteinheit 22a weist eine Wirkverbindung mit dem Formgedächtniselement 14a auf. Im vorliegenden Fall ist die Magneteinheit 22a zumindest teilweise identisch mit der Magnetstelleinheit 20a. Dabei ist die zweite Induktivität 50a Teil der Magneteinheit 22a. Hierdurch kann insbesondere eine besonders kompakte und/oder energieeffiziente Aktorvorrichtung bereitgestellt werden.

Im vorliegenden Fall ist die Magneteinheit 22a dazu vorgesehen, in dem weiteren Betriebszustand mittels eines Formveränderungsmagnetfelds eine Verformung des Formgedächtniselements 14a zu bewirken, sodass das Formgedächtniselement 14a dazu vorgesehen ist, eine Bewegung des Aktorelements 12a in die erste Bewegungsrichtung 16a und die zweite Bewegungsrichtung 18a mittels der magnetischen Verformung zumindest teilweise zu hemmen. Dabei wirkt die magnetische Verformung vorteilhaft mit der mechanischen Verformung des Formgedächtniselements 14a zusammen, wodurch insbesondere eine Dämpfungshärte des Formgedächtniselements 14a eingestellt werden kann.

Zudem kann die Magneteinheit 22a dazu vorgesehen sein, in dem weiteren Betriebszustand das Formgedächtniselement 14a derart mit einem weiteren Formveränderungsmagnetfeld zu beaufschlagen, dass eine Bewegung des Aktorelements 12a in die erste Bewegungsrichtung 16a und/oder die zweite Bewegungsrichtung 18a mittels einer Formveränderung des Formgedächtniselements 14a bewirkt wird, wodurch beispielsweise eine Vorpositionierung des Formgedächtniselements 14a erreicht werden kann. Alternativ ist denkbar, eine Magneteinheit vollständig separat von einer Magnetstelleinheit auszubilden. Dabei könnte die Magneteinheit insbesondere auch zumindest zwei, zumindest drei und/oder zumindest vier Induktivitäten, wie beispielsweise Spulen und/oder Elektromagneten, aufweisen. Zudem könnte auf eine, insbesondere zusätzliche, Magneteinheit prinzipiell auch verzichtet werden. In letzterem Fall könnte ein Magnetfeld zur Beeinflussung eines Formgedächtniselements prinzipiell auch einem aus einem Umgebungsbereich auf einen Aktor einwirkendem Magnetfeld entsprechen.

Darüber hinaus umfasst die Aktorvorrichtung im vorliegenden Fall eine Sicherungseinheit 24a. Die Sicherungseinheit 24a stellt dabei eine Fail-Safe-Funktion bereit, wodurch eine Notabschaltung des Aktors 26a und/oder zumindest der Aktorvorrichtung realisiert werden kann. Die Sicherungseinheit 24a ist dazu vorgesehen, in zumindest einem Fehlerbetriebszustand, wie beispielsweise bei einer Überschreitung einer bestimmten Temperatur, bei einem Defekt oder Ausfall eines Bauteils der Aktorvorrichtung, wie beispielsweise der Versorgungselektronik 46a und/oder des Aktorelements 12a, und/oder bei einem Stromausfall, eine Bewegung des Aktorelements 12a in eine definierte Stellposition zu bewirken. Im vorliegenden Fall ist die Sicherungseinheit 24a in dem Fehlerbetriebszustand dazu vorgesehen, die Magnetstelleinheit 20a anzusteuern, um das Aktorelement 12a mittels eines Stellmagnetfelds in die definierte Stellposition zu bewegen. Dazu weist die Sicherungseinheit 24a eine elektrische Verbindung mit der Magnetstelleinheit 20a auf. Alternativ könnte eine Sicherungseinheit jedoch auch zu einer Bewegung eines Formgedächtniselements vorgesehen sein und beispielsweise eine Wirkverbindung mit einer Magneteinheit aufweisen. Zudem ist denkbar, insbesondere im Falle einer Verwendung eines thermisch aktiven Formgedächtniselements ein thermisch induziertes Fail-Safe-Verhalten zu realisieren, wobei bei Überschreiten einer charakteristischen Phasenumwandlungstemperatur ein Formgedächtniselement verformt wird und hierdurch ein Aktorelement in eine definierte Stellposition bringt.

Zudem umfasst die Sicherungseinheit 24a ein, im vorliegenden Fall insbesondere als Batterie ausgebildetes, Energiespeicherelement 52a, wodurch eine Betriebssicherheit insbesondere auch im Falle eines Stromausfalls gewährleistet werden kann. Alternativ könnte ein Energiespeicherelement auch als Akkumulator und/oder Kondensator ausgebildet sein. Zudem könnte auf ein Energiespeicherelement auch verzichtet werden. Darüber hinaus ist denkbar, auf eine Sicherungseinheit vollständig zu verzichten.

Die Figuren 2a bis 2e zeigen einen beispielhaften Schaltzyklus der Aktorvorrichtung.

Figur 2a zeigt das Aktorelement 12a in einer, insbesondere beispielhaften, ersten Stellposition und das Formgedächtniselement 14a in einer, insbesondere beispielhaften, ersten Form. Die erste Stellposition entspricht im vorliegenden Fall einer Position, in welcher der Stellabschnitt 38a zentral zwischen den Anschlagflächen 42a, 44a angeordnet ist. In diesem Betriebszustand ist die Magnetstelleinheit 20a und insbesondere die erste Induktivität 48a und die zweite Induktivität 50a unbetrieben. Dabei wird das Aktorelement 12a mittels des Formgedächtniselements 14a in der ersten Stellposition gehalten.

Figur 2b zeigt eine Bewegung des Aktorelements 12a in die erste Bewegungsrichtung 16a und insbesondere einen damit korrelierten Expansionsvorgang des Formgedächtniselements 14a. Zur Bewegung des Aktorelements 12a in die erste Bewegungsrichtung 16a wird dabei die erste Induktivität 48a mittels der Versorgungselektronik 46a mit einem Gleichstrom beaufschlagt, wodurch insbesondere ein Stellmagnetfeld zur Bewegung des Stellabschnitts 38a bewirkt und/oder induziert wird. Als Folge verformt sich das Formgedächtniselement 14a rein mechanisch, wobei durch die mechanische Verformung die Bewegung des Aktorelements 12a gehemmt wird. In diesem Betriebszustand ist die zweite Induktivität 50a unbetrieben.

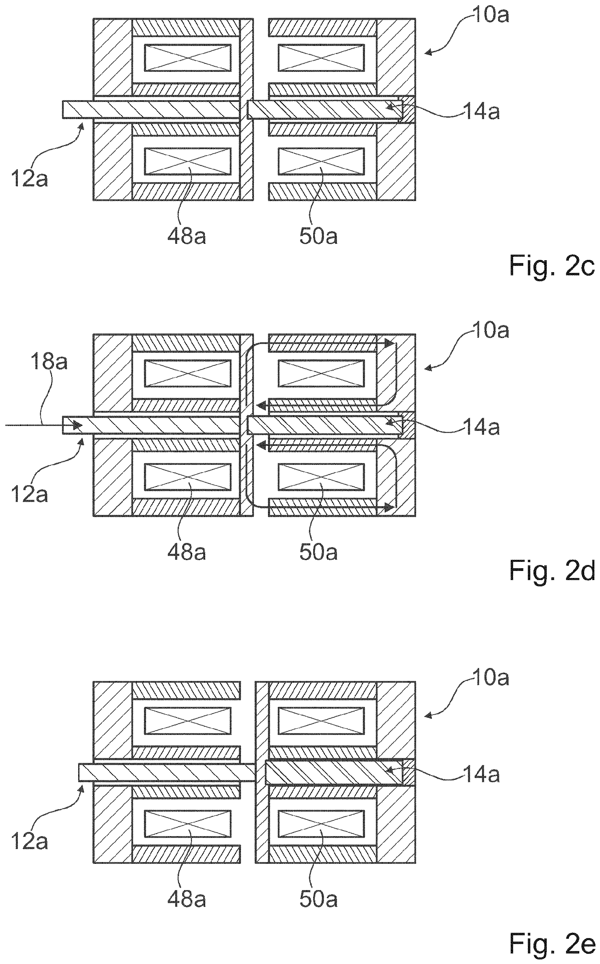

Figur 2c zeigt das Aktorelement 12a in einer, insbesondere beispielhaften, zweiten Stellposition und das Formgedächtniselement 14a in einer, insbesondere beispielhaften, zweiten Form. Die zweite Stellposition entspricht im vorliegenden Fall einer Position, in welcher der Stellabschnitt 38a an einer ersten Anschlagfläche 42a der Anschlagflächen 42a, 44a anliegt. In diesem Betriebszustand ist die Magnetstelleinheit 20a und insbesondere die erste Induktivität 48a und die zweite Induktivität 50a unbetrieben. Dabei wird das Aktorelement 12a mittels des Formgedächtniselements 14a in der zweiten Stellposition gehalten.

Figur 2d zeigt eine Bewegung des Aktorelements 12a in die zweite Bewegungsrichtung 18a und insbesondere einen damit korrelierten Kompressionsvorgang des Formgedächtniselements 14a. Zur Bewegung des Aktorelements 12a in die zweite Bewegungsrichtung 18a wird dabei die zweite Induktivität 50a mittels der Versorgungselektronik 46a mit einem Gleichstrom beaufschlagt, wodurch insbesondere ein weiteres Stellmagnetfeld zur Bewegung des Stellabschnitts 38a bewirkt und/oder induziert wird. Als Folge verformt sich das Formgedächtniselement 14a rein mechanisch, wobei durch die mechanische Verformung die Bewegung des Aktorelements 12a gehemmt wird. In diesem Betriebszustand ist die erste Induktivität 48a unbetrieben.

Figur 2e zeigt das Aktorelement 12a in einer, insbesondere beispielhaften, dritten Stellposition und das Formgedächtniselement 14a in einer, insbesondere beispielhaften, dritten Form. Die dritte Stellposition entspricht im vorliegenden Fall einer Position, in welcher der Stellabschnitt 38a an einer zweiten Anschlagfläche 44a der Anschlagflächen 42a, 44a anliegt. In diesem Betriebszustand ist die Magnetstelleinheit 20a und insbesondere die erste Induktivität 48a und die zweite Induktivität 50a unbetrieben. Dabei wird das Aktorelement 12a mittels des Formgedächtniselements 14a in der dritten Stellposition gehalten.

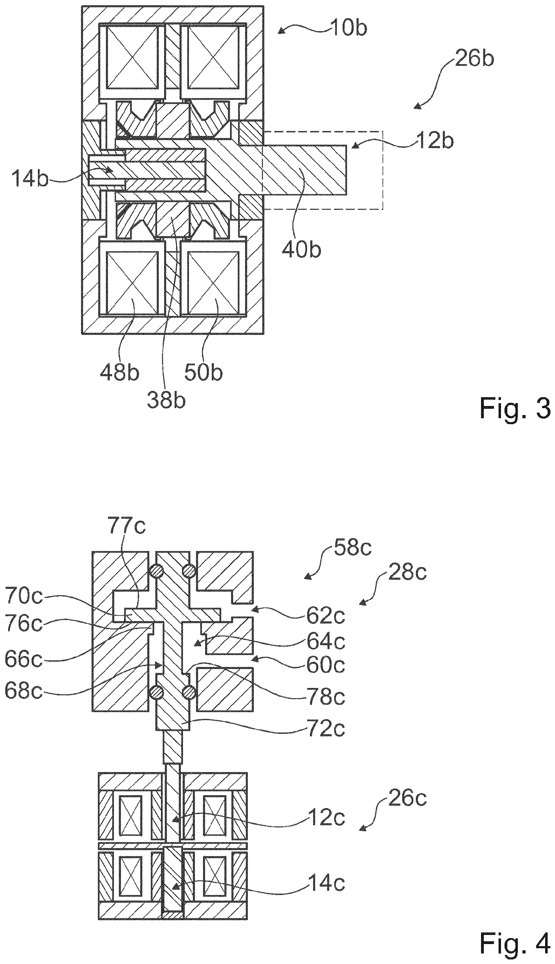

In den Figuren 3 bis 5 sind weitere Ausführungsbeispiele der Erfindung gezeigt. Die nachfolgenden Beschreibungen und die Zeichnungen beschränken sich im Wesentlichen auf die Unterschiede zwischen den Ausführungsbeispielen, wobei bezüglich gleich bezeichneter Bauteile, insbesondere in Bezug auf Bauteile mit gleichen Bezugszeichen, grundsätzlich auch auf die Zeichnungen und/oder die Beschreibung der anderen Ausführungsbeispiele, insbesondere der Figuren 1 bis 2e, verwiesen werden kann. Zur Unterscheidung der Ausführungsbeispiele ist der Buchstabe a den Bezugszeichen des Ausführungsbeispiels in den Figuren 1 bis 2e nachgestellt. In den Ausführungsbeispielen der Figuren 3 bis 5 ist der Buchstabe a durch die Buchstaben b bis d ersetzt.

In Figur 3 ist ein weiteres Ausführungsbeispiel der Erfindung gezeigt. Dem Ausführungsbeispiel der Figur 3 ist der Buchstabe b nachgestellt. Das weitere Ausführungsbeispiel der Figur 3 zeigt ein Anwendungsbeispiel eines Aktors 26b entsprechend des vorherigen Ausführungsbeispiels.

In Figur 3 ist dabei beispielhaft ein als sogenannter "Moving Magnet Voice-Coil-Aktor" ausgebildeter Aktor 26b dargestellt. Die Aktorvorrichtung entspricht in diesem Fall zumindest im Wesentlichen der Aktorvorrichtung des vorhergehenden Ausführungsbeispiels.

In Figur 4 ist ein weiteres Ausführungsbeispiel der Erfindung gezeigt. Dem Ausführungsbeispiel der Figur 4 ist der Buchstabe c nachgestellt. Das weitere Ausführungsbeispiel der Figur 4 zeigt ein weiteres Anwendungsbeispiel eines Aktors 26c entsprechend der vorherigen Ausführungsbeispiele.

Figur 4 zeigt ein beispielhaft als Sitzventil ausgebildetes Ventil 28c. Das Ventil 28c ist steuerbar ausgebildet. Das Ventil 28c ist als Proportionalventil ausgebildet. Das Ventil 28c ist im vorliegenden Fall zudem als fluiddruckunterstützt arbeitendes Ventil ausgebildet. Alternativ ist jedoch auch denkbar, ein Ventil als Schieberventil oder beliebiges anderes Ventil auszubilden.

Das Ventil 28c umfasst eine Fluidaufnahmeeinheit 58c. Die Fluidaufnahmeeinheit 58c ist als Fluidgehäuse ausgebildet Die Fluidaufnahmeeinheit 58c weist eine Einlassöffnung 60c und eine Auslassöffnung 62c auf. Die Einlassöffnung 60c ist zu einer Einleitung eines, im vorliegenden Fall insbesondere gasförmigen, Fluidstroms vorgesehen. Die Auslassöffnung 62c ist zu einer Ausleitung des Fluidstroms vorgesehen. Die Fluidaufnahmeeinheit 58c definiert ferner zumindest eine, im vorliegenden Fall insbesondere genau eine, Fluidleitung 64c. Die Fluidleitung 64c verbindet die Einlassöffnung 60c mit der Auslassöffnung 62c. Die Fluidleitung 64c ist dazu vorgesehen, den Fluidstrom zumindest teilweise zu führen. Das Ventil 28c und insbesondere die Fluidaufnahmeeinheit 58c ist dabei frei von einer Bypassleitung und/oder einem Pilotventil.

Das Ventil 28c umfasst ferner einen Ventilsitz 66c. Der Ventilsitz 66c ist innerhalb der Fluidaufnahmeeinheit 58c angeordnet. Der Ventilsitz 66c begrenzt dabei die Fluidleitung 64c zumindest teilweise.

Darüber hinaus weist das Ventil 28c eine Verschlusseinheit 68c auf. Die Verschlusseinheit 68c ist zu wenigstens einem Großteil innerhalb der Fluidaufnahmeeinheit 58c angeordnet. Die Verschlusseinheit 68c ist ferner zumindest teilweise innerhalb der Fluidleitung 64c angeordnet. Die Verschlusseinheit 68c steht in Wirkverbindung mit dem Ventilsitz 66c. Die Verschlusseinheit 68c ist beweglich relativ zu dem Ventilsitz 66c ausgebildet. Im vorliegenden Fall ist die Verschlusseinheit 68c dabei linear beweglich ausgebildet. Die Verschlusseinheit 68c ist dazu vorgesehen, in einer Verschlussstellung mit dem Ventilsitz 66c zusammenzuwirken, um die Fluidleitung 64c zu verschließen.

Dazu umfasst die Verschlusseinheit 68c zumindest ein Verschlusselement 70c. Das Verschlusselement 70c ist vollständig innerhalb der Fluidleitung 64c angeordnet. Das Verschlusselement 70c ist einstückig ausgebildet. Das Verschlusselement 70c ist zumindest im Wesentlichen tellerförmig ausgebildet. Das Verschlusselement 70c ist als Drosselelement ausgebildet. Das Verschlusselement 70c kontaktiert in der Verschlussstellung den Ventilsitz 66c. Das Verschlusselement 70c liegt in der Verschlussstellung fluiddicht an dem Ventilsitz 66c an. Dazu kann das Verschlusselement 70c ein, insbesondere in Umfangrichtung umlaufendes, vorteilhaft elastisches, Dichtelement umfassen. Alternativ ist jedoch auch denkbar, ein Verschlusselement mehrteilig auszubilden und/oder zumindest im Wesentlichen kugelförmig.

Ferner umfasst die Verschlusseinheit 68c einen Ventilstößel 72c. Der Ventilstößel 72c ist einstückig ausgebildet. Der Ventilstößel 72c besteht zumindest teilweise aus einem magnetischen Material. Der Ventilstößel 72c weist eine Wirkverbindung mit dem Verschlusselement 70c auf. Im vorliegenden Fall kontaktiert der Ventilstößel 72c das Verschlusselement 70c unmittelbar. Dabei ist der Ventilstößel 72c einstückig mit dem Verschlusselement 70c ausgebildet. Der Ventilstößel 72c weist eine Haupterstreckungsrichtung auf, welche senkrecht zu einer Haupterstreckungsebene des Verschlusselements 70c angeordnet ist. Der Ventilstößel 72c ist dabei aus der Fluidaufnahmeeinheit 58c hinausgeführt. Der Ventilstößel 72c dient zu einer, insbesondere steuerbaren, Bewegung des Verschlusselements 70c. Alternativ könnte ein Ventilstößel auch mehrteilig und/oder separat von einem Verschlusselement ausgebildet sein.

Des Weiteren umfasst die Verschlusseinheit 68c im vorliegenden Fall mehrere Fluiddruckflächen 76c, 77c, 78c. Im vorliegenden Fall umfasst die Verschlusseinheit 68c zumindest drei Fluiddruckflächen 76c, 77c, 78c. Die Fluiddruckflächen 76c, 77c, 78c sind senkrecht zu einer Bewegungsrichtung der Verschlusseinheit 68c angeordnet. Eine erste Fluiddruckfläche 76c der Fluiddruckflächen 76c, 77c, 78c ist auf einer dem Ventilsitz 66c zugewandten Seite des Verschlusselements 70c angeordnet. Eine zweite Fluiddruckfläche 77c der Fluiddruckflächen 76c, 77c, 78c ist auf einer dem Ventilsitz 66c abgewandten Seite des Verschlusselements 70c angeordnet. Eine dritte Fluiddruckfläche 78c der Fluiddruckflächen 76c, 77c, 78c ist an dem Ventilstößel 72c angeformt. Die dritte Fluiddruckfläche 78c ist dem Verschlusselement 70c zugewandt. Alle Fluiddruckflächen 76c, 77c, 78c weichen dabei mit einem Flächenanteil von zumindest 10 % voneinander ab. Vorteilhaft ist jedoch eine Flächensumme der zweiten Fluiddruckfläche 77c und der dritten Fluiddruckfläche 78c identisch zu der ersten Fluiddruckfläche 76c. Die Fluiddruckflächen 76c, 77c, 78c sind dazu vorgesehen, eine Bewegung der Verschlusseinheit 68c zu beeinflussen, wodurch eine fluiddruckunterstützte Bewegung der Verschlusseinheit 68c erreicht und/oder zumindest in einer Öffnungsstellung der Verschlusseinheit 68c, in welcher insbesondere ein Fluidstrom von der Einlassöffnung 60c zu der Auslassöffnung 62c ermöglicht ist, ein druckausgeglichenes Ventil realisiert werden kann. Alternativ könnte eine Verschlusseinheit eine andere Anzahl an Fluiddruckflächen aufweisen, wie beispielsweise zumindest vier Fluiddruckflächen.

Darüber hinaus umfasst das Ventil 28c den Aktor 26c mit einer erfindungsgemäßen Aktorvorrichtung. Der Aktor 26c entspricht dabei im Wesentlichen einem Aktor 26a eines ersten Ausführungsbeispiels. Der Aktor 26c und insbesondere ein Betätigungsabschnitt 40c eines Aktorelements 12c ist im vorliegenden Fall dazu vorgesehen, eine Bewegung der Verschlusseinheit 68c zu bewirken und diese insbesondere zumindest teilweise mittels eines Formgedächtniselements 14c zu hemmen. Dazu kontaktiert das Aktorelement 12c den Ventilstößel 72c unmittelbar. Das Aktorelement 12c ist dazu vorgesehen, eine Hubkraft und/oder Schiebekraft auf die Verschlusseinheit 68c und insbesondere den Ventilstößel 72c auszuüben. Hierdurch ist das Aktorelement 12c dazu vorgesehen, die Verschlusseinheit 68c entgegen einer zumindest von einem Fluiddruck bewirkten Druckschließkraft aus der Verschlussstellung in wenigstens eine Öffnungsstellung und vorteilhaft eine Vielzahl unterschiedlicher Öffnungsstellungen zu bewegen. Zudem ist das Aktorelement 12c dazu vorgesehen, eine Zugkraft und/oder Rückstellkraft auf die Verschlusseinheit 68c und insbesondere den Ventilstößel 72c auszuüben, wodurch die Verschlusseinheit 68c insbesondere in die Verschlussstellung zurückbewegt werden kann.

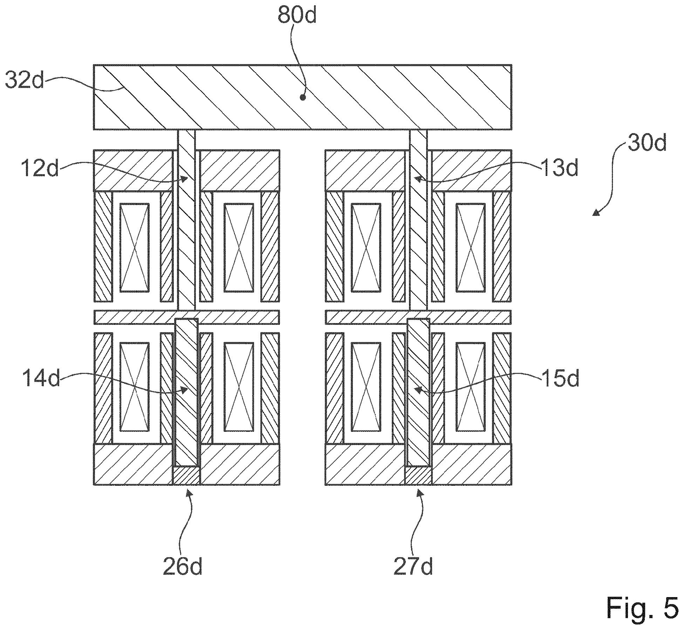

In Figur 5 ist ein weiteres Ausführungsbeispiel der Erfindung gezeigt. Dem Ausführungsbeispiel der Figur 5 ist der Buchstabe d nachgestellt. Das weitere Ausführungsbeispiel der Figur 5 zeigt ein weiteres Anwendungsbeispiel eines Aktors 26d, 27d entsprechend der vorherigen Ausführungsbeispiele.

Figur 5 zeigt ein beispielhaft als optisches Positionierungssystem ausgebildetes Positionierungssystem 30d. Das Positionierungssystem 30d dient im vorliegenden Fall zur Positionierung zumindest eines optischen Bauelements 32d.

Das optische Bauelement 32d ist beispielhaft als Spiegel ausgebildet und beweglich um eine Lagerachse 80d gelagert.

Zur Positionierung des optischen Bauelements 32d umfasst das Positionierungssystem 30d im vorliegenden Fall beispielhaft zwei Aktoren 26d, 27d jeweils mit einer erfindungsgemäßen Aktorvorrichtung. Die Aktoren 26d, 27d sind im vorliegenden Fall zumindest im Wesentlichen identisch zueinander und weisen jeweils ein Aktorelement 12d, 13d sowie ein Formgedächtniselement 14d, 15d auf. Die Aktoren 26d, 27d entsprechen dabei im Wesentlichen einem Aktor 26a eines ersten Ausführungsbeispiels.

Die Aktorelemente 12d, 13d weisen eine Wirkverbindung mit dem optischen Bauelement 32d auf. Die Aktorelemente 12d, 13d sind im vorliegenden Fall dazu vorgesehen, jeweils eine Bewegung des optischen Bauelements 32d um die Lagerachse 80h zu bewirken. Zudem sind die Formgedächtniselemente 14d, 15d dazu vorgesehen, eine Bewegung der Aktorelemente 12d, 13d und/oder des optischen Bauelements 32d zumindest teilweise zu hemmen. Alternativ ist denkbar, genau einen Aktor zu verwenden, insbesondere um eine lineare Positionierung eines optischen Bauelements zu erreichen. Zudem ist denkbar, einen Aktor mit mehreren Aktorelementen und/oder weitere Aktoren, wie beispielsweise zumindest drei und/oder zumindest vier Aktoren, vorteilhaft jeweils mit einer erfindungsgemäßen Aktorvorrichtung, zu verwenden. Ferner ist denkbar, unterschiedliche Aktoren, vorteilhaft jeweils mit einer erfindungsgemäßen Aktorvorrichtung, zu verwenden. In letzterem Fall ist jedoch prinzipiell auch denkbar, zumindest einen Aktor der Aktoren als herkömmlichen Aktor, insbesondere ohne formveränderliches Formgedächtniselement, auszugestalten.

## Patentansprüche

1. Aktorvorrichtung mit zumindest einer statischen Einheit (10a; 10b), mit zumindest einem relativ zu der statischen Einheit (10a; 10b) beweglichen elektromagnetischen Aktorelement (12a-d; 13d) und mit zumindest einem Formgedächtniselement (14a-d; 15d), welches zumindest teilweise aus einem formveränderlichen Formgedächtnismaterial besteht, wobei das Formgedächtniselement (14a-d; 15d) mittelbar oder unmittelbar mit dem Aktorelement (12a-d; 13d) verbunden ist, wobei das Formgedächtniselement (14a-d; 15d) dazu vorgesehen ist, in zumindest einem Betriebszustand eine Bewegung des Aktorelements (12a-d; 13d) in eine erste Bewegungsrichtung (16a) und eine Bewegung des Aktorelements (12a-d; 13d) in eine von der ersten Bewegungsrichtung (16a) abweichende und der ersten Bewegungsrichtung (16a) entgegengesetzte zweite Bewegungsrichtung (18a) zumindest mittels einer mechanischen Verformung eines formveränderlichen Formgedächtnismaterials des Formgedächtniselements (14a-d; 15d) zumindest teilweise zu hemmen, und dadurch das Aktorelement (12a-d; 13d) in einer Stellposition zu halten.

2. Aktorvorrichtung nach Anspruch 1, wobei das Formgedächtniselement (14a-d; 15d) von einer wenigstens temporär stabilen ersten Form in zumindest eine wenigstens temporär stabile zweite Form überführbar ist.

3. Aktorvorrichtung nach Anspruch 2, wobei das Formgedächtniselement (14a-d; 15d) in zumindest eine wenigstens temporär stabile dritte Form überführbar ist.

4. Aktorvorrichtung nach einem der vorhergehenden Ansprüche, wobei das Formgedächtniselement (14a-d; 15d) mit der statischen Einheit (10a; 10b) verbunden ist.

5. Aktorvorrichtung nach Anspruch 4, wobei das Formgedächtniselement (14a-d; 15d) mit dem Aktorelement (12a-d; 13d) und/oder der statischen Einheit (10a; 10b) mittels einer Klemmverbindung, einer Klebeverbindung, einer Vergußverbindung und/oder einer Schweißverbindung verbunden ist.

6. Aktorvorrichtung nach einem der vorhergehenden Ansprüche, wobei eine maximale Bewegungsstrecke des Aktorelements (12a-d; 13d) entlang zumindest einer Richtung zumindest 1 % und/oder höchstens 20 % einer minimalen Erstreckung des Formgedächtniselements (14a-d; 15d) entlang der Richtung entspricht.

7. Aktorvorrichtung nach einem der vorhergehenden Ansprüche, wobei zumindest eine Magnetstelleinheit (20a) dazu vorgesehen ist, eine Bewegung des Aktorelements (12a-d; 13d) zu bewirken.

8. Aktorvorrichtung nach einem der vorhergehenden Ansprüche, wobei das Formgedächtnismaterial zumindest teilweise aus einer Nickel-Titan Legierung, einer Nickel-Titan-haltigen Legierung, einer Nickel-Mangan-Gallium Legierung, einer Nickel-Mangan-Gallium-haltigen Legierung, einer Kupfer-Zink-Aluminium Legierung und/oder einer Kupfer-Aluminium-Nickel Legierung besteht.

9. Aktorvorrichtung nach einem der vorhergehenden Ansprüche, wobei das Formgedächtnismaterial als Kompositmaterial ausgebildet ist.

10. Aktorvorrichtung nach einem der vorhergehenden Ansprüche, wobei das Formgedächtnismaterial ein magnetisch aktives Material, insbesondere ein magnetisches Formgedächtnismaterial, ist.

11. Aktorvorrichtung nach Anspruch 10, wobei zumindest eine Magneteinheit (22a) dazu vorgesehen ist, in zumindest einem weiteren Betriebszustand eine Form des Formgedächtniselements (14a-d; 15d) zu beeinflussen.

12. Aktorvorrichtung nach Anspruch 11, wobei die Magneteinheit (22a) dazu vorgesehen ist, in dem weiteren Betriebszustand mittels eines Formveränderungsmagnetfelds eine Verformung des Formgedächtniselements (14a-d; 15d) zu bewirken und das Formgedächtniselement (14a-d; 15d) dazu vorgesehen ist, eine Bewegung des Aktorelements (12a-d; 13d) in die erste Bewegungsrichtung (16a) und/oder die zweite Bewegungsrichtung (18a) mittels der magnetischen Verformung zumindest teilweise zu hemmen.

13. Aktorvorrichtung nach einem der vorhergehenden Ansprüche, wobei zumindest eine Sicherungseinheit (24a) dazu vorgesehen ist, in zumindest einem Fehlerbetriebszustand eine Bewegung des Aktorelements (12a-d; 13d) und/oder des Formgedächtniselements (14a-d; 15d) in eine definierte Form und/oder Lage zu bewirken.

14. Aktor (26a-d, 27d) mit zumindest einer Aktorvorrichtung nach einem der vorhergehenden Ansprüche.

15. Ventil (28c) mit zumindest einer Aktorvorrichtung nach einem der Ansprüche 1 bis 13.

16. Positionierungssystem (30d) mit zumindest einer Aktorvorrichtung nach einem der Ansprüche 1 bis 13, insbesondere zur Positionierung optischer Bauelemente (32d).

17. Verfahren zum Betrieb einer Aktorvorrichtung, mit zumindest einer statischen Einheit (10a; 10b), mit zumindest einem relativ zu der statischen Einheit (10a; 10b) beweglichen elektromagnetischen Aktorelement (12a-d; 13d) und mit zumindest einem Formgedächtniselement (14a-d; 15d), welches zumindest teilweise aus einem formveränderlichen Formgedächtnismaterial besteht, wobei von dem mittelbar oder unmittelbar mit dem Aktorelement (12a-d; 13d) verbundenen Formgedächtniselement (14a-d; 15d) in zumindest einem Betriebszustand eine Bewegung des Aktorelements (12a-d; 13d) in eine erste Bewegungsrichtung (16a) und eine Bewegung des Aktorelements (12a-d; 13d) in eine von der ersten Bewegungsrichtung (16a) abweichende und der ersten Bewegungsrichtung (16a) entgegengesetzte zweite Bewegungsrichtung (18a) zumindest mittels einer mechanischen Verformung eines formveränderlichen Formgedächtnismaterials des Formgedächtniselements (14a-d; 15d) zumindest teilweise gehemmt wird und dadurch das Aktorelement (12a-d; 13d) in der jeweiligen Stellposition gehalten wird.

## Claims

1. Actuator device
with at least one stationary unit (10a; 10b),
with at least one electromagnetic actuator element (12a-d; 13d) which is movable relative to the stationary unit (10a; 10b), and
with at least one shape-memory element (14a-d; 15d), which is implemented at least partly of a shape-shiftable shape-memory material, wherein the shape-memory element (14a-d; 15d) is indirectly or directly connected with the actuator element (12a-d; 13d),
wherein the shape-memory element (14a-d; 15d) is configured, in at least one operation state, to at least partly hinder a movement of the actuator element (12a-d; 13d) in a first movement direction (16a) and a movement of the actuator element (12a-d; 13d) in a second movement direction (18a) that differs from the first movement direction (16a) and is opposed to the first movement direction (16a) at least via a mechanical deformation of a shape-shiftable shape-memory material of the shape-memory element (14a-d; 15d), thus holding the actuator element (12a-d; 13d) in a set position.

2. Actuator device according to claim 1,
wherein the shape-memory element (14a-d; 15d) is transferable from an at least temporarily stable first shape into at least one at least temporarily stable second shape.

3. Actuator device according to claim 2,
wherein the shape-memory element (14a-d; 15d) is transferable into at least one at least temporarily stable third shape.

4. Actuator device according to one of the preceding claims,
wherein the shape-memory element (14a-d; 15d) is connected with the stationary unit (10a; 10b).

5. Actuator device according to claim 4,
wherein the shape-memory element (14a-d; 15d) is connected with the actuator element (12a-d; 13d) and/or with the stationary unit (10a; 10b) via a clamp connection, via a glue connection, via a socketing connection and/or via a welding connection.

6. Actuator device according to one of the preceding claims,
wherein a maximum movement distance of the actuator element (12a-d; 13d) along at least one direction is equivalent to at least 1 % and/or to maximally 20 % of a minimum extension of the shape-memory element (14a-d; 15d) along the direction.

7. Actuator device according to one of the preceding claims,
wherein at least one magnetic setting unit (20a) is configured to bring about a movement of the actuator element (12a-d; 13d).

8. Actuator device according to one of the preceding claims,
wherein the shape-memory material is implemented at least partly of a nickel-titanium alloy, an alloy containing nickel and titanium, a nickel-manganese-gallium alloy, an alloy containing nickel, manganese and gallium, a copper-zinc-aluminum alloy and/or a copper-aluminum-nickel alloy.

9. Actuator device according to one of the preceding claims,
wherein the shape-memory material is implemented as a composite material.

10. Actuator device according to one of the preceding claims,
wherein the shape-memory material is a magnetically active material, in particular a magnetic shape-memory material.

11. Actuator device according to claim 10,
wherein at least one magnet unit (22a) is configured, in at least one further operating state, to influence a shape of the shape-memory element (14a-d; 15d).

12. Actuator device according to claim 11,
wherein the magnet unit (22a) is configured, in the further operation state, to effect a deformation of the shape-memory element (14a-d; 15d) via a shape-shifting magnetic field, and that the shape-memory element (14a-d; 15d) is configured to at least partly hinder a movement of the actuator element (12a-d; 13d) in the first movement direction (16a) and/or in the second movement direction (18a) by means of the magnetic deformation.

13. Actuator device according to one of the preceding claims,
wherein at least one securing unit (24a) is configured, in at least one error operation state, to bring about a movement of the actuator element (12a-d; 13d) and/or of the shape-memory element (14a-d; 15d) into a defined shape and/or position.

14. Actuator (26a-d, 27d) with at least one actuator device according to one of the preceding claims.

15. Valve (28c) with at least one actuator device according to one of claims 1 to 13.

16. Positioning system (30d) with at least one actuator device according to one of claims 1 to 13, in particular for a positioning of optical structural elements (32d).

17. Method for an operation of an actuator device,
with at least one stationary unit (10a; 10b),
with at least one electromagnetic actuator element (12a-d; 13d) which is movable relative to the stationary unit (10a; 10b), and
with at least one shape-memory element (14a-d; 15d) which is implemented at least partly of a shape-shiftable shape-memory material, wherein in at least one operation state a movement of the actuator element (12a-d; 13d) in a first movement direction (16a) and a movement of the actuator element (12a-d; 13d) in a second movement direction (18a) that differs from the first movement direction (16a) and is opposed to the first movement direction (16a) is at least partly hindered by the shape-memory element (14a-d; 15d), which is connected indirectly or directly with the actuator element (12a-d; 13d), at least via a mechanical deformation of a shape-shiftable shape-memory material of the shape-memory element (14a-d; 15d),
and as a result the actuator element (12a-d; 13d) is held in the respective set position.

## Revendications

1. Dispositif actionneur
avec au moins une unité stationnaire (10a ; 10b),
avec au moins un élément actionneur électro-magnétique (12a-d ; 13d) qui est mobile par rapport à l'unité stationnaire (10a ; 10b) et
avec au moins un élément à mémoire de forme (14a-d ; 15d) fait au moins partiellement d'un matériau changeant-forme à mémoire de forme,
où l'élément à mémoire de forme (14a-d ; 15d) est relié indirectement ou directement avec l'élément actionneur (12a-d ; 13d),
où l'élément à mémoire de forme (14a-d ; 15d) est conçu, dans au moins un état de fonctionnement, pour au moins partiellement inhiber un mouvement de l'élément actionneur (12a-d ; 13d) dans une première direction de mouvement (16a) et un mouvement de l'élément actionneur (12a-d ; 13d) dans une deuxième direction de mouvement (18a) différant de la première direction de mouvement (16a) et opposée à la première direction de mouvement (16a) au moins par une déformation mécanique d'un matériau changeant-forme à mémoire de forme de l'élément à mémoire de forme (14a-d ; 15d) et pour ce faisant maintenir l'élément actionneur (12a-d ; 13d) dans une position réglée.

2. Dispositif actionneur selon la revendication 1,
où l'élément à mémoire de forme (14a-d ; 15d) peut être converti d'une première forme au moins temporairement stable dans au moins une deuxième forme au moins temporairement stable.

3. Dispositif actionneur selon la revendication 2,
où l'élément à mémoire de forme (14a-d ; 15d) peut être converti dans au moins une troisième forme au moins temporairement stable.

4. Dispositif actionneur selon l'une des revendications précédentes,
où l'élément à mémoire de forme (14a-d ; 15d) est relié avec l'unité stationnaire (10a ; 10b).

5. Dispositif actionneur selon la revendication 4,
où l'élément à mémoire de forme (14a-d ; 15d) est relié avec l'élément actionneur (12a-d ; 13d) et/ou avec l'unité stationnaire (10a ; 10b) moyennant une liaison de serrage, une liaison adhésive, une liaison de scellement et/ou une liaison à soudage.

6. Dispositif actionneur selon l'une des revendications précédentes,
où un chemin maximal de l'élément actionneur (12a-d ; 13d) le long d'au moins une direction est équivalent à au moins 1 % et/ou maximalement 20 % d'une étendue minimale de l'élément à mémoire de forme (14a-d ; 15d) le long de ladite direction.

7. Dispositif actionneur selon l'une des revendications précédentes,
où au moins une unité d'ajustement magnétique (20a) est conçue pour causer un mouvement de l'élément actionneur (12a-d ; 13d).

8. Dispositif actionneur selon l'une des revendications précédentes,
où le matériau à mémoire de forme est réalisé au moins partiellement d'un alliage nickel-titane, d'un alliage contenant de nickel-titane, d'un alliage nickel-manganèse-gallium, d'un alliage contenant de nickel-manganèse-gallium, d'un alliage cuivre-zinc-aluminium et/ou d'un alliage cuivre-aluminium-nickel.

9. Dispositif actionneur selon l'une des revendications précédentes,
où le matériau à mémoire de forme est réalisé comme matériau composite.

10. Dispositif actionneur selon l'une des revendications précédentes,
où le matériau à mémoire de forme est un matériau magnétiquement actif, en particulier un matériau magnétique à mémoire de forme.

11. Dispositif actionneur selon la revendication 10,
où au moins une unité magnétique (22a) est conçue pour influencer en au moins un autre état de fonctionnement une forme de l'élément à mémoire de forme (14ad ; 15d).

12. Dispositif actionneur selon la revendication 11,
où l'unité magnétique (22a) est conçue, en l'autre état de fonctionnement, pour causer une déformation de l'élément à mémoire de forme (14a-d ; 15d) par le biais d'un champ magnétique changeant-forme, et
l'élément à mémoire de forme (14a-d ; 15d) est conçu pour au moins partiellement inhiber par la déformation magnétique un mouvement de l'élément actionneur (12a-d ; 13d) dans la première direction de mouvement (16a) et/ou dans la deuxième direction de mouvement (18a).

13. Dispositif actionneur selon l'une des revendications précédentes,
où au moins une unité de sécurité (24a) est conçue pour causer dans au moins un état de fonctionnement à erreur un mouvement de l'élément actionneur (12a-d ; 13d) et/ou de l'élément à mémoire de forme (14a-d ; 15d) dans une forme et/ou position définie.

14. Actionneur (26a-d, 27d) avec au moins un dispositif actionneur selon l'une des revendications précédentes.

15. Soupape (28c) avec au moins un dispositif actionneur selon l'une des revendications 1 à 13.

16. Système de positionnement (30d) avec au moins un dispositif actionneur selon l'une des revendications 1 à 13, en particulier pour le positionnement d'éléments structurels optiques (32d).

17. Procédé de fonctionnement d'un dispositif actionneur,
avec au moins une unité stationnaire (10a ; 10b),
avec au moins un élément actionneur électro-magnétique (12a-d ; 13d) qui est mobile par rapport à l'unité stationnaire (10a ; 10b) et
avec au moins un élément à mémoire de forme (14a-d ; 15d) fait au moins partiellement d'un matériau changeant-forme à mémoire de forme,
où dans au moins un état de fonctionnement un mouvement de l'élément actionneur (12a-d ; 13d) dans une première direction de mouvement (16a) et un mouvement de l'élément actionneur (12a-d ; 13d) dans une deuxième direction de mouvement (18a) différant de la première direction de mouvement (16a) et opposée à la première direction de mouvement (16a) sont au moins partiellement inhibés moyennant l'élément à mémoire de forme (14a-d ; 15d) relié indirectement ou directement avec l'élément actionneur (12a-d ; 13d) au moins par une déformation mécanique d'un matériau changeant-forme à mémoire de forme de l'élément à mémoire de forme (14a-d ; 15d) et ainsi l'élément actionneur (12a-d ; 13d) est maintenu dans la position réglée respective.
